# FASCICULE DE BREVET EUROPEEN

(11) **EP 2 327 160 B1**
(45) Date de publication et mention de la délivrance du brevet: **08.02.2012**
(21) Numéro de dépôt: 09747882.0
(22) Date de dépôt: 15.09.2009
(51) Int. Cl.: H04N 5/33, H03K 25/02, H04N 5/3745

(54) **COMPTEUR ANALOGIQUE ET IMAGEUR INCORPORANT UN TEL COMPTEUR**
ANALOGZÄHLER UND EIN EINEN SOLCHEN ZÄHLER ENTHALTENDEN BILDGEBER
ANALOG COUNTER, AND IMAGER INCORPORATING SUCH A COUNTER

(30) Priorité: 18.09.2008 FR 0856301
(43) Date de publication de la demande: 01.06.2011
(73) Titulaire: Commissariat à l'Énergie Atomique et aux Énergies Alternatives, 75015 Paris (FR)
(72) Inventeur: MANDIER, Christophe, F-38110 La Tour-du-Pin (FR); CHAMMINGS, Gilles, F-38100 Grenoble (FR); DUPONT, Bertrand, F-84400 Gargas (FR); TCHAGASPANIAN, Michaël, F-38330 Saint Ismier (FR)
(74) Mandataire: Bonnans, Arnaud
(86) Numéro de dépôt international: PCT/FR2009/051728
(87) Numéro de publication internationale: WO 2010/031952

(56) Documents cités:
- EP-A- 1 858 245
- WO-A-98/06178
- DE-A1- 19 526 878
- US-A1- 2007 285 300

## Description

L'invention concerne un compteur analogique et un imageur, notamment infrarouge, incorporant un tel compteur analogique. Un exemple de compteur analogique est décrit par exemple dans la demande de brevet EP 1 858 245.

Les imageurs, notamment dans le domaine infrarouge, sont classiquement formés d'un grand nombre de pixels aptes chacun à mesurer la quantité de rayonnement qu'il reçoit (chaque pixel étant en général associé à une direction particulière du rayonnement reçu au moyen d'un système optique).

La grandeur physique mesurée au niveau de chaque pixel (au moyen d'un capteur prévu à cet effet) doit être convertie en un signal facilement exploitable, par exemple de type numérique.

Il a dans ce cadre été prévu qu'une partie du traitement de conversion soit intégrée à chaque pixel de l'imageur de manière notamment à ne transmettre à l'extérieur du pixel que des signaux suffisamment robustes.

On sait que l'on recherche par ailleurs à réduire autant que possible les dimensions des pixels, ce qui implique notamment de réduire les dimensions des circuits de traitement prévus comme expliqué ci-dessus dans chaque pixel.

Il a dans ce contexte été proposé par l'article "A Multi-Spectral Analog Photon Counting Read-Out circuit for X-ray Hybrid Pixel Detectors", de M. Prenzoni et al. in Instrumentation and Measurements Technology Conference, Sorrento, Italie, 24-27 avril 2006 [IMTC 2006], IEEE, pp. 2003-2006 d'utiliser des compteurs analogiques en lieu et place de compteurs binaires afin de réduire la surface nécessaire.

La mise en oeuvre proposée dans ce document est toutefois rudimentaire et il est souhaitable d'améliorer en particulier la répétabilité et la précision du compteur afin d'obtenir un imageur de bonne qualité.

L'invention propose ainsi un compteur analogique comprenant, pour au moins un étage, une entrée destinée à recevoir des impulsions électriques, des moyens pour modifier par incréments ou décréments successifs une tension de stockage à chaque impulsion reçue et des moyens de réinitialisation de la tension de stockage, comprenant un comparateur de la tension de stockage à un seuil apte à générer une information de dépassement et des moyens de commande aptes à commander les moyens de réinitialisation en cas de détection simultanée de l'information de dépassement du comparateur et d'une impulsion en entrée.

La réinitialisation (dont la mise en oeuvre peut éventuellement être utilisée en tant que signal d'entrée de l'étage suivant) est ainsi faite en synchronisme avec une impulsion reçue en entrée, ce qui assure un fonctionnement précis du compteur.

Le comparateur peut comprendre des moyens de maintien de l'information de dépassement en l'absence de réinitialisation (notamment en attente de l'impulsion suivante), c'est-à-dire jusqu'à une réinitialisation ultérieure, ce qui permet d'assurer que la réinitialisation aura bien lieu malgré la condition mentionnée plus haut.

On peut prévoir également que le comparateur soit apte à générer l'information de dépassement postérieurement à la présence de l'impulsion en entrée ayant entraîné la tension de stockage au-delà du seuil, ce qui permet de déclencher la réinitialisation précisément sur l'impulsion suivant celle ayant entraîné le dépassement du seuil et d'utiliser ainsi complètement l'excursion en tension prévue pour la tension de stockage.

On peut ainsi prévoir de rendre possible la détection simultanée de l'information de dépassement et de l'impulsion en entrée uniquement lors de la réception d'une impulsion postérieure à une impulsion en entrée ayant entraîné la génération de l'information de dépassement.

En pratique, le comparateur a par exemple un temps de réponse supérieur à la durée des impulsions et inférieur à la période séparant deux impulsions, ce qui permet que l'information de dépassement apparaisse après l'impulsion en entrée ayant entraîné la tension de stockage au-delà du seuil mais avant l'impulsion suivante, qui entraînera donc la réinitialisation.

Le compteur analogique peut comprendre en outre des moyens pour forcer la tension de stockage à une tension prédéterminée supérieure au seuil, commandés par un signal de réinitialisation forcée. On réalise ainsi de manière particulièrement astucieuse des moyens de réinitialisation forcée de l'étage.

Les moyens de commande peuvent être aptes à transmettre, à destination de l'entrée d'un étage suivant, une impulsion conditionnée par la présence de l'information de dépassement et de ladite impulsion en entrée. Les deux étages concernés travaillent ainsi de manière synchrone et le comptage est donc particulièrement précis. L'impulsion transmise à l'étage suivant peut en pratique être appliquée en tant que signal de commande desdits moyens de réinitialisation, ce qui simplifie la conception du dispositif.

Les moyens pour modifier la tension de stockage comprennent par exemple en pratique un circuit d'injection de charges, qui peut éventuellement lui-même comprendre trois transistors PMOS en série, dont deux transistors d'extrémité qui reçoivent sur la grille respectivement un signal porteur des impulsions et un signal complémentaire dudit signal porteur.

Le comparateur peut quant à lui comprendre deux transistors formant une paire différentielle et recevant respectivement sur leur grille la tension de stockage et le seuil, ainsi qu'un transistor commandé par l'information de dépassement et connecté en parallèle du transistor recevant le seuil de manière à le court-circuiter en présence de l'information de dépassement. On obtient ainsi de manière particulièrement simple une fonction d'hystérésis comme expliqué plus en détail dans la suite.

On peut prévoir par ailleurs que les moyens de commande comprennent un inverseur recevant en entrée l'information de dépassement et dont une borne de polarisation est connectée à ladite entrée, ce qui permet de réaliser de manière simple la détection de la condition susmentionnée. Un autre inverseur peut en outre mettre en forme l'information de dépassement reçue du comparateur, en particulier lorsque le comparateur génère en sortie une rampe de tension du fait de son temps de réponse précédemment évoqué.

Selon une possibilité de mise en oeuvre décrite plus loin, le compteur analogique comprend au moins une capacité (par exemple deux capacités) mémorisant au moins temporairement la tension de stockage et connectée aux moyens pour modifier la tension de stockage par l'intermédiaire d'un transistor, de manière à pouvoir sélectivement déconnecter la capacité de ces moyens notamment dans le but de lire la valeur mémorisée.

Une paire différentielle peut en outre recevoir la tension de stockage, tout en étant sélectivement alimentée en fonction d'un signal de lecture, de manière à transmettre la valeur mémorisée à l'extérieur du pixel à travers la paire différentielle sur commande du signal de lecture.

L'invention propose également un imageur comprenant des moyens de mesure générant un signal électrique porteur d'impulsions dont la fréquence est représentative d'un rayonnement reçu, et un compteur analogique tel que décrit ci-dessus, le signal électrique étant appliqué à ladite entrée.

D'autres caractéristiques et avantages de l'invention apparaîtront mieux à la lumière de la description qui suit, faite en référence aux dessins annexés dans lesquels :
- la figure 1 représente les éléments principaux d'un pixel d'un imageur incorporant un compteur analogique conforme aux enseignements de la présente invention ;
- la figure 2 représente schématiquement les éléments fonctionnels d'un exemple de compteur analogique réalisé conformément aux enseignements de l'invention ;
- la figure 3 représente un exemple détaillé de réalisation possible pour un étage du compteur analogique de la figure 2 ;
- la figure 4 représente la conception du bus permettant la connexion de l'étage représenté à la figure 3 aux autres éléments de la colonne de pixels concernée ;
- la figure 5 illustre le comportement temporel de certains signaux présents dans le circuit de la figure 3.

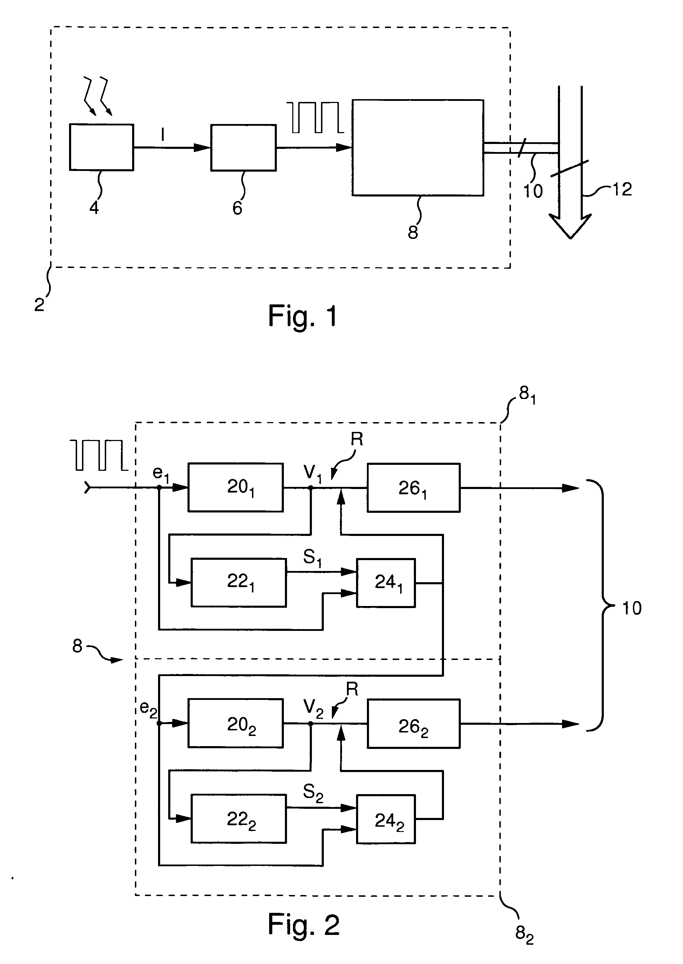

La figure 1 représente le schéma général d'un pixel 2 d'imageur infrarouge comprenant un compteur réalisé selon les enseignements de l'invention. Un imageur infrarouge est naturellement composé d'une matrice d'un grand nombre de tels pixels 2.

Chaque pixel 2 comprend un capteur 4 (comprenant par exemple un micro-bolomètre et un transistor de polarisation) apte à générer un courant I indicatif (c'est-à-dire variable en fonction) du flux de rayonnement infrarouge reçu dans une bande passante donnée.

Le courant I ainsi généré est appliqué à un circuit de conversion courant-fréquence qui émet en sortie des impulsions électriques à une fréquence dépendant du courant I.

On remarque que les impulsions électriques peuvent être constituées par un niveau logique haut ou en variante par un niveau logique bas (comme d'ailleurs représenté sur la figure 1 et dans les exemples décrits ci-après).

Les impulsions électriques émises par le circuit de conversion 6 sont appliquées à un compteur analogique 8, décrit en détail dans la suite, et dont le rôle consiste principalement à compter le nombre d'impulsions reçues sur une durée prédéterminée (le compteur 8 étant réinitialisé avec une période égale à cette durée) dans le but d'émettre en sortie sur un bus 10 des signaux représentant le nombre compté, et par conséquent représentatifs du flux de rayonnement infrarouge reçu par le capteur 4.

Comme cela ressortira notamment des explications qui suivent, le compteur 8 génère sur chaque élément conducteur du bus 10 une tension sur un nombre prédéterminé N de niveaux (et qui représente par conséquent sur chaque élément conducteur un entier compris entre 0 et N-1), de telle sorte que l'ensemble du bus représentera le nombre d'impulsions compté en base N, d'où l'appellation compteur base N (où N est de préférence strictement supérieur à 2 afin d'obtenir les avantages en termes de réduction de surface déjà mentionnés).

Les niveaux de tension portés par le bus 10 peuvent alors être transmis sur un bus principal 12 sur lequel sont transmises successivement (c'est-à-dire par multiplexage temporel) les valeurs mesurées pour les différents pixels d'une colonne en vue de les convertir en numérique puis de les mémoriser.

Des variantes sont naturellement envisageable, comme par exemple la conversion analogique-numérique des signaux présents sur le bus 10 avant leur transmission en pied de colonne au moyen du bus principal 12. On peut prévoir également des mécanismes de sauvegarde temporaire des niveaux de tension au moyen de capacités.

La figure 2 représente sous forme d'un schéma fonctionnel général un exemple de réalisation du compteur 8.

Le compteur 8 représenté à la figure 2 comprend un premier étage 8₁ et un second étage 8₂. On peut naturellement prévoir un nombre supérieur d'étages, chaque étage étant chaîné à l'étage suivant de la même manière que le premier étage 8₁ est chaîné au second étage 8₂ comme décrit plus bas.

Tous les étages (ici le premier 8₁ et le second étage 8₂) sont formés sur la même architecture et on va donc décrire à présent l'architecture d'un étage 8_{i.}

Chaque étage 8ᵢ reçoit en entrée un train d'impulsions électriques eᵢ qui est alors appliqué d'une part à un circuit d'injection de charges 20ᵢ et d'autre part à un circuit de réinitialisation 24ᵢ (sur lequel on reviendra plus loin).

Le circuit d'injection de charges 20ᵢ est conçu pour augmenter sa tension de sortie Vᵢ d'une valeur fixe (ou incrément de tension) ΔV à chaque impulsion du signal eᵢ (impulsion qui correspond à un niveau bas dans l'exemple décrit ici comme déjà mentionné). Cette augmentation du niveau de tension d'un incrément fixe est obtenue en pratique par l'injection par le circuit 20ᵢ d'une quantité fixe de charges, maintenues au point noté R (qui porte la tension Vᵢ) du fait de la présence d'une capacité dans le circuit de mémorisation 26ᵢ comme décrit plus en détail dans la suite.

Des circuits de ce type sont par exemple décrits dans la demande de brevet FR 2 888 074.

On utilise par exemple 8 niveaux analogiques (N=8) pour une excursion en tension de l'ordre de 1,4 V, ici entre un niveau analogique le plus bas de 0 V (potentiel de la masse GND) et un niveau analogique le plus haut d'environ 1,4 V (la tension d'alimentation étant de 1,8 V). On pourrait naturellement prévoir des valeurs différentes ; le niveau analogique le plus bas pourrait par exemple être non nul.

La tension Vᵢ est appliquée notamment à l'entrée d'un comparateur 22ᵢ qui génère en sortie un signal de dépassement Sᵢ lorsque la tension Vᵢ a atteint son niveau analogique le plus haut (ce qui est déterminé par exemple par comparaison à un seuil légèrement inférieur à ce niveau analogique).

Le comparateur 22ᵢ comprend un mécanisme d'hystérésis de sorte que, une fois que la tension Vᵢ a dépassé le seuil, l'information de dépassement Sᵢ est maintenue tant que la tension Vᵢ n'est pas revenue à son niveau analogique le plus bas comme expliqué à présent.

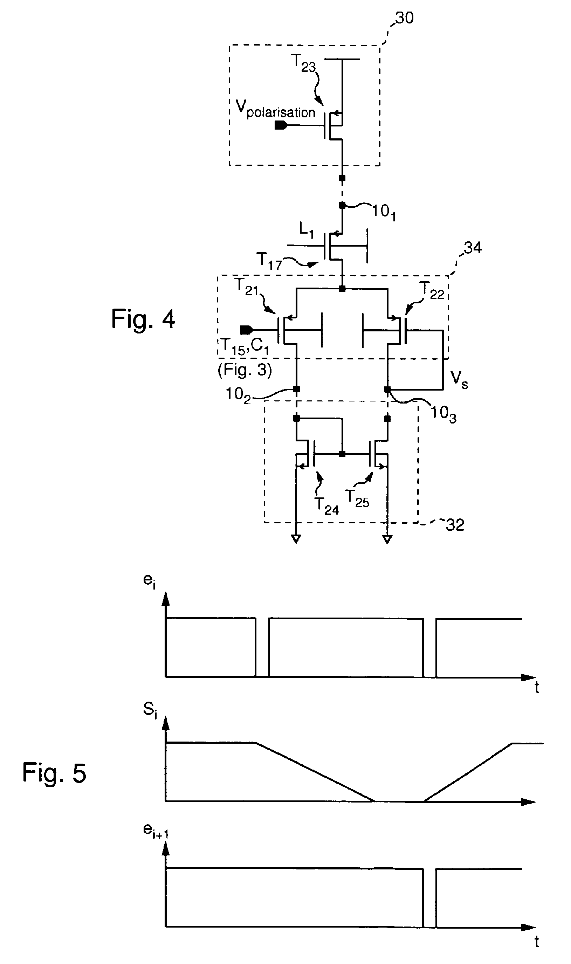

Le comparateur 22ᵢ a par ailleurs un temps de réponse supérieur à la durée des impulsions eᵢ (mais inférieur à la durée séparant deux impulsions) de telle sorte que l'information de dépassement Si est générée après l'impulsion ayant provoqué son apparition, comme illustré en figure 5. En pratique, les impulsions ayant une durée de l'ordre de quelques nanosecondes (moins de 10 ns) et étant séparées l'une de l'autre d'au minimum 300 ns, on peut prévoir un temps de réponse de l'ordre de 100 ns.

L'information de dépassement Sᵢ est appliquée au circuit de réinitialisation 24ᵢ, qui reçoit également le signal eᵢ porteur d'impulsions reçu en entrée.

Le circuit de réinitialisation 24ᵢ commande le retour de la tension Vᵢ au niveau analogique le plus bas lorsqu'il reçoit en entrée à la fois l'information de dépassement Sᵢ et une impulsion du signal d'entrée eᵢ. Comme on le verra dans la suite, la réinitialisation est par exemple réalisée par la décharge de la capacité de mémorisation de la tension Vᵢ déjà mentionnée ci-dessus. On notera alors que la durée nécessaire à l'annulation de l'information de dépassement après réception d'une impulsion est de préférence supérieure à la durée de cette impulsion et inférieure à la durée minimale entre deux impulsions consécutives.

Comme déjà indiqué, le circuit de mémorisation 26ᵢ permet la mémorisation temporaire (notamment durant le comptage) de la tension Vᵢ au moyen d'une capacité, puis, lorsque la durée de comptage est écoulée, la transmission de la tension Vᵢ obtenue en fin de comptage (qui représente donc le nombre d'impulsions reçues dans l'entrée eᵢ modulo N) sur le bus 10.

Le signal émis en sortie du circuit de réinitialisation 24ᵢ est par ailleurs transmis en tant que signal d'entrée eᵢ₊₁ de l'étage suivant (sauf naturellement lorsqu'il s'agit du dernier étage), comme montré en figure 2 où la sortie du circuit de réinitialisation 24₁ est appliquée en tant que signal d'entrée e₂ du second étage 8₂, et donc en pratique au circuit d'injection 20₂ et au circuit de réinitialisation 24₂ du second étage 8₂.

Chaque étage (à partir du second étage) compte ainsi une impulsion lorsque l'étage précédent, après avoir balayé les N niveaux analogiques, est réinitialisé (ce qui constitue le principe de base du comptage en base N).

On remarque que, du fait que le circuit de réinitialisation 24ᵢ émet son signal en sortie seulement en présence d'une impulsion dans le signal eᵢ qu'il reçoit en entrée, les impulsions de ce signal de sortie du circuit de réinitialisation 24ᵢ sont synchrones avec les impulsions du signal eᵢ sur le plan de la phase (c'est-à-dire de l'instant de début des impulsions). De plus, dans le cas où l'annulation de l'information de dépassement est suffisamment lente par rapport à l'impulsion du signal eᵢ l'ayant généré, les impulsions du signal de sortie du circuit de réinitialisation 24ᵢ sont sensiblement de même durée que les impulsions du signal eᵢ.

L'utilisation de ce signal en sortie comme entrée de l'étage suivant, permet ainsi d'une part de faire correspondre précisément les impulsions reçues à l'étage eᵢ₊₁ à celles du signal eᵢ reçues en entrée de l'étage précédent, et donc d'obtenir un fonctionnement synchrone des différents étages.

De plus, la durée des impulsions en entrée étant la même pour l'étage concerné (signal eᵢ) et l'étage suivant (signal eᵢ₊₁), la quantité de charge injectée par les divers circuits d'injection 20ᵢ, qui dépend naturellement de la durée des impulsions reçues en entrée, est particulièrement homogène sur l'ensemble des étages, ce qui permet d'obtenir des incréments en tension identiques dans les différents étages.

L'architecture présentée ci-dessus permet par ailleurs, en particulier grâce au temps de réaction du comparateur, de déclencher la remise à zéro précisément lors de l'arrivée de l'impulsion suivant celle qui a entraîné le dépassement du seuil (c'est-à-dire l'arrivée au dernier niveau de tension analogique) ce qui entraîne ici aussi un fonctionnement très précis du compteur (alors qu'à l'opposé la réinitialisation sur la base de la simple information de dépassement prévue dans les systèmes classiques serait prématurée et entraînerait la perte du dernier niveau analogique).

Cette propriété permet ainsi d'utiliser pleinement l'excursion en tension. Par rapport aux systèmes classiques, on peut soit obtenir un niveau analogique supplémentaire pour un même incrément en tension (avec une sensibilité au bruit identique), soit obtenir un incrément en tension plus grand pour un nombre de niveaux identique et donc avoir un meilleur rapport signal/bruit.

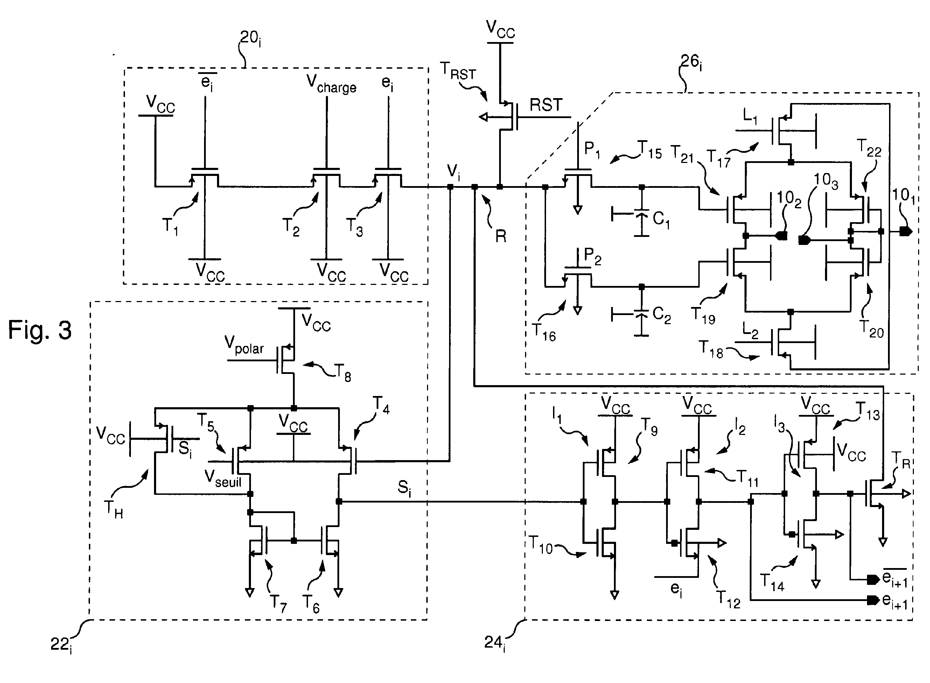

La figure 3 représente un exemple détaillé de mise en oeuvre envisageable pour chaque étage 8₁, 8₂ du compteur de la figure 2.

On remarque d'ores et déjà que, dans cette mise en oeuvre détaillée, on utilise non seulement les signaux eᵢ porteur d'impulsions en entrée de chaque étage, mais également le signal complémentaire eᵢ .

On note par ailleurs que, sur la figure 3, l'alimentation de certains circuits par la tension d'alimentation nominale du circuit électronique est notée V_{cc} (ici V_{cc}=1,8 V), tandis que la connexion à un triangle représente une connexion à la masse.

Le circuit d'injection de charges 20ᵢ comprend trois transistors PMOS T₁, T₂, T₃ connectés en série (c'est-à-dire le drain de l'un étant relié à la source de l'autre), la source du premier T₁ de ces trois transistors PMOS étant reliée à la tension V_{cc} tandis que le drain du troisième transistor PMOS T₃ forme la sortie du circuit d'injection 20ᵢ, où s'établit la tension Vᵢ représentative du nombre d'impulsions dénombrées.

Le premier transistor T₁ reçoit sur sa grille le signal *e̅̅̅ᵢ* complémentaire du signal d'entrée eᵢ, le second transistor T₂ reçoit sur sa grille une tension fixe V_{charge} et le troisième transistor T₃ reçoit sur sa grille le signal d'entrée eᵢ.

Ainsi, lorsqu'une impulsion arrive dans le signal d'entrée eᵢ (une impulsion étant représentée par un niveau bas de ce signal dans l'exemple décrit ici comme déjà mentionné ci-dessus), le troisième transistor PMOS T₃ devient passant (tandis que le premier transistor T₁ est bloqué du fait de l'application du signal complémentaire *e̅ᵢ̅*) de sorte que les charges précédemment accumulées entre les premier et troisième transistors T₁, T₃ (avant l'arrivée de l'impulsion) sont transférées à la sortie du circuit d'injection 20ᵢ et provoquent donc l'augmentation de la tension Vᵢ d'un incrément prédéterminé ΔV.

Une fois l'impulsion dans le signal eᵢ passée, le troisième transistor T₃ se bloque tandis que le premier transistor T₁ devient passant, ce qui provoque l'accumulation de charges à transmettre en sortie au cours de l'impulsion suivante.

La tension fixe V_{charge} est fournie par une source de tension et utilisée par plusieurs étages, voire plusieurs pixels. Le niveau de cette tension fixe V_{charge} est constant au cours du fonctionnement d'acquisition mais on peut prévoir qu'il soit variable, par exemple au cours d'une phase de calibration, de manière à régler la quantité de charges transmises à chaque impulsion.

On utilise par ailleurs de préférence dans le circuit d'injection 20ᵢ des transistors PMOS comme déjà indiqué du fait de la faiblesse généralement constatée de leur courant de fuite par rapport à des transistors réalisés en technologie NMOS.

Comme déjà mentionné à propos de la figure 2, la tension Vᵢ en sortie du circuit d'injection 20ᵢ (point R) est appliquée en entrée du comparateur 22ᵢ, où elle est comparée à une tension fixe Vₛₑᵤᵢₗ légèrement inférieure (par exemple d'environ 100 mV dans le présent exemple où les niveaux analogiques diffèrent d'environ 200 mV) au niveau analogique le plus haut que peut prendre la tension Vᵢ. On notera ici également que la tension est éventuellement réglable lors d'une phase de calibration précédant le fonctionnement normal, dans le but notamment de compenser des dispersions technologiques éventuelles (défaut d'uniformité des valeurs obtenues en pratique sur l'ensemble des pixels).

Le comparateur 22ᵢ comprend un transistor PMOS T₄ dont la grille reçoit la tension Vᵢ et un transistor PMOS T₅ dont la grille reçoit la tension Vₛₑᵤᵢₗ, les transistors T₄ et T₅ étant reliés par leurs sources respectives à un point où est également connecté le drain d'un transistor PMOS T₈ dont la source est mise à la tension d'alimentation V_{cc} et dont la grille reçoit une tension de polarisation Vₚₒₗₐᵣ.

Les drains des transistors T₄ et T₅ sont respectivement reliés à la masse GND par un transistor NMOS T₆ et par un transistor NMOS T₇ (ayant chacun leur source à la masse), les transistors T₆ et T₇ étant reliés par leurs grilles respectives à un point également connecté au drain du transistor T₇.

On prévoit également de relier la source et le drain du transistor T₅ avec interposition d'un transistor PMOS T_{H} (les sources des transistors T₅ et T_{H} étant en contact) de manière à créer une branche dite "*d'hystérésis*", le transistor T_{H} recevant également sur sa grille la tension Sᵢ présente au niveau du drain du transistor T₄.

Tant que la tension Vᵢ est inférieure à la tension Vₛₑᵤᵢₗ, la tension Sᵢ (présente notamment au niveau du drain du transistor T₄ comme il vient d'être indiqué) est au niveau haut (représentatif dans l'exemple décrit ici d'une absence d'information de dépassement).

Le transistor T_{H}, auquel est également appliquée la tension Sᵢ et qui permet de générer la fonction d'hystérésis comme décrit plus bas, est alors désactivé.

Lorsque la tension Vᵢ augmente du fait du comptage des impulsions comme décrit plus haut jusqu'à dépasser la tension Vₛₑᵤᵢₗ, la tension Sᵢ passe, avec le temps de réaction déjà mentionné (cf. figure 5), à zéro (indiquant ainsi le dépassement du seuil au circuit de réinitialisation 24ᵢ avec les conséquences détaillées ci-après), ce qui a en outre pour effet de commander la fermeture du transistor T_{H} et d'activer la branche dite "*d'hystérésis*" qui comporte ce transistor T_{H} et qui court-circuite de ce fait le transistor T₅ du comparateur qui reçoit la tension Vₛₑᵤᵢₗ.

De ce fait, le comparateur continuera à délivrer l'information de dépassement (Sᵢ à zéro) tant que la tension Vᵢ ne sera elle-même revenue à zéro du fait de la réinitialisation à venir comme expliqué à présent.

Comme déjà indiqué, l'information de dépassement portée par la tension Sᵢ est appliquée en entrée du circuit de réinitialisation 24ᵢ.

Le circuit de réinitialisation 24ᵢ comprend successivement trois inverseurs I₁, I₂, I₃.

Le premier inverseur I₁ comprend un transistor PMOS T₉ et un transistor NMOS T₁₀ reliés par leurs drains respectifs (en un point qui constitue la sortie du premier inverseur I₁) et recevant chacun la tension Sᵢ sur leur grille, les sources des transistors T₉ et T₁₀ étant reliées respectivement à la tension d'alimentation V_{CC} et à la masse GND.

Le second inverseur I₂ comprend un transistor PMOS T₁₁ et un transistor NMOS T₁₂ reliés par leurs drains respectifs (en un point qui constitue la sortie du second inverseur I₂) et recevant chacun la sortie du premier inverseur I₁ sur leur grille, la source du transistor T₁₁ étant reliée à la tension d'alimentation V_{CC} tandis que le signal eᵢ reçu en entrée de l'étage concerné est appliqué à la source du transistor T₁₂.

Le signal en sortie du second inverseur I₂ est transmis à l'étage suivant en tant que signal d'entrée eᵢ₊₁ comme expliqué ci-après.

Le troisième inverseur I₃ comprend un transistor PMOS T₁₃ et un transistor NMOS T₁₄ reliés par leurs drains respectifs (en un point qui constitue la sortie du troisième inverseur I₃) et recevant chacun la sortie du second inverseur I₂ sur leur grille, les sources des transistors T₁₃ et T₁₄ étant reliées respectivement à la tension d'alimentation V_{CC} et à la masse GND.

Le signal en sortie du troisième inverseur I₃ est notamment transmis à l'étage suivant en tant que signal eᵢ₊₁ complémentaire du signal d'entrée eᵢ₊₁.

On explique à présent le fonctionnement de ces trois inverseurs en série.

Comme déjà indiqué, la tension Sᵢ est appliquée à l'entrée du premier inverseur I₁ qui génère donc en sortie un signal dans lequel l'information de dépassement générée par le comparateur 22ᵢ correspond à un niveau haut.

On remarque que le premier inverseur I₁ réalise une remise en forme du signal Sᵢ (qui présente la forme d'une rampe de tension du fait du temps de réaction du comparateur supérieur à la durée des impulsions comme déjà mentionné) et que l'on peut ainsi considérer que l'information de dépassement est générée lorsque que le signal Sᵢ est suffisamment faible pour entraîner le basculement du premier inverseur I₁, ici vers un niveau haut en sortie.

Le second inverseur I₂ reçoit quant à lui (au niveau de la source du transistor NMOS T₁₂ comme déjà indiqué) le signal eᵢ porteur d'impulsions et reçu en entrée de l'étage 8ᵢ concerné de telle sorte que la sortie du second inverseur I₂ est à un niveau bas si et seulement si sont présentes simultanément une impulsion (niveau bas) dans le signal eᵢ et l'information de dépassement reçue du comparateur 22ᵢ. La sortie du second inverseur I₂ peut ainsi être utilisée en tant que signal d'entrée eᵢ₊₁ de l'étage suivant, avec des impulsions sensiblement synchrones à celles du signal eᵢ (le décalage temporel généré par le second inverseur I₂ étant négligeable dans la présente application).

Ce signal est également appliqué au troisième inverseur I₃ ce qui permet de générer à la fois le signal complémentaire *̅e̅i̅*̅+̅1̅ destiné à l'étage suivant et la commande d'un transistor de réinitialisation NMOS T_{R} qui décharge, lorsqu'il devient passant (c'est-à-dire lorsque le signal en sortie du troisième inverseur I₃ est au niveau haut), la tension Vᵢ accumulée en sortie du circuit injecteur 20ᵢ, ce qui provoque la réinitialisation (ou remise à zéro) de l'étage du compteur.

On remarque qu'on a ainsi un très bon synchronisme entre la réinitialisation (ou remise à zéro) d'un étage 8ᵢ et le comptage d'une impulsion à l'étage 8_{i+1,} caractéristiques du comptage en base N.

Selon une variante envisageable, on pourrait remplacer les deux inverseurs I₁ et I₂ par une bascule de type flip-flop et obtenir les mêmes fonctionnalités : la bascule reçoit dans ce cas en entrée le signal Sᵢ et sur son entrée d'horloge le signal eᵢ, ce qui permet d'obtenir en sortie un signal eᵢ₊₁ conforme à ce qui est décrit ci-dessus.

La réinitialisation, qui vient d'être décrite comme conséquence de l'atteinte du niveau analogique le plus haut par la tension de sortie Vᵢ, peut également être commandée par application d'une impulsion d'un signal RST à la grille d'un transistor PMOS T_{RST} dont le drain est relié au point R (porteur de la tension Vᵢ) et dont la source est connectée à la tension d'alimentation V_{cc} : le transistor T_{RST} devenant passant, la tension nominale (tension d'alimentation) V_{cc} est appliquée au point R ; la tension Vᵢ est alors égale à la tension d'alimentation V_{cc} et par conséquent supérieure au niveau analogique le plus haut (et donc à la tension Vₛₑᵤᵢₗ), ce qui déclenche le fonctionnement déjà décrit au sein du comparateur 22ᵢ et du circuit de réinitialisation 24ᵢ et par suite la réinitialisation de la tension Vᵢ.

On notera que la réinitialisation du compteur s'effectue en pratique lors de l'arrivée d'une impulsion en entrée du compteur. Ce type de réinitialisation est préférable à une réinitialisation au moyen d'un transistor NMOS de décharge. En effet, lors de l'ouverture d'un tel transistor NMOS après décharge, une tension négative peut apparaître sur le point R. Ceci accentue les fuites des transistors reliés à ce noeud et il est alors difficile d'assurer un niveau bas analogique fixe et déterminé. Cette incertitude sur le niveau du point R peut en outre être accentuée si le temps d'attente entre la réinitialisation et le comptage effectif n'est pas maîtrisé. Ainsi, en réinitialisant le compteur comme indiqué ci-dessus, à un moment où on souhaite comptabiliser des impulsions en entrée, il est possible de maitriser la tension présente sur le noeud R après réinitialisation. En outre, le fait d'assurer une réinitialisation du noeud R à une tension égale ou supérieure à la masse, permet de diminuer les fuites parasites vers le noeud R de chaque étage. Le niveau analogique bas est ainsi sensiblement le même pour chaque étage indépendamment de l'instant de début de comptage de chaque étage.

On obtient ainsi de manière très simple un mécanisme de réinitialisation forcé de l'étage, qui utilise en outre les mêmes éléments et le même processus que la réinitialisation de l'étage à chaque dépassement du seuil lors du comptage, ce qui permet d'obtenir dans tous les cas une réinitialisation identique de la tension Vᵢ (et donc bien calibrée) ; ce mécanisme est notamment utilisé pour remettre à zéro le compteur (réinitialisation forcée de tous les étages du compteur) lorsque la durée de comptage est écoulée (et naturellement après mémorisation de la valeur comme décrit maintenant).

Le circuit de mémorisation 26ᵢ comprend deux capacités C₁, C₂, chacune étant connectée à la sortie du circuit d'injection 20ᵢ (point R de tension Vᵢ) par un transistor NMOS (respectivement noté T₁₅, T₁₆) commandé respectivement par des signaux P₁, P₂.

Les signaux appliqués P₁, P₂ sont tel qu'en fonctionnement une seule des deux capacités C₁, C₂ est connectée à la sortie du circuit d'injection 20ᵢ, la capacité connectée (par exemple C₁) permettant la mémorisation (ou stockage) temporaire de la valeur pendant la durée du comptage.

Lorsque cette durée est écoulée, le transistor précédemment fermé s'ouvre (du fait naturellement de sa commande appropriée, dans l'exemple par le signal P₁) ce qui permet d'isoler la capacité concernée (dans l'exemple C₁) et de conserver la valeur représentative du nombre d'impulsions dénombré.

On peut alors fermer le transistor permettant la connexion de l'autre capacité (dans l'exemple C₂) à la sortie du circuit d'injection 20ᵢ et commander la réinitialisation forcée de l'étage (simultanément d'ailleurs à celle des autres étages du compteur) par commande à l'aide du signal RST comme mentionné plus haut.

Le dénombrement des impulsions reçues reprend donc avec mémorisation temporaire sur cet autre transistor (C₂ dans l'exemple). On profite de cette nouvelle durée de comptage pour transmettre la valeur mémorisée sur la première capacité (C₁ dans l'exemple) vers le bus 10 comme décrit ci-après (lecture de la valeur mémorisée sur la capacité vers le bus 10 à l'aide de circuits suiveurs commandés par les signaux de lecture L₁, L₂).

Chaque capacité C₁, C₂ est en effet connectée au bus 10 par l'intermédiaire d'une paire différentielle alimentée à travers un transistor PMOS (respectivement noté T₁₇, T₁₈) recevant sur sa grille le signal de lecture (respectivement L₁, L₂).

Plus précisément, la borne de la capacité C₁ liée au transistor T₁₅ est également connectée à la grille d'un transistor PMOS T₂, dont la source est reliée d'une part à la source d'un transistor PMOS T₂₂ (pour former la paire différentielle) et d'autre part au drain du transistor T₁₇. La grille du transistor T₂₂ est par ailleurs reliée au drain de ce même transistor T₂₂.

Le bus 10 est ici formé de trois fils 10₁, 10₂, 10₃ connectés respectivement à la source du transistor T₁₇ (pour connexion à une source de courant en tête de colonne comme expliqué plus loin), au drain du transistor T₂₁ et au drain du transistor T₂₂ (pour connexion à un miroir de courant en pied de colonne comme expliqué plus loin).

De manière identique, la borne de la capacité C₂ liée au transistor T₁₆ est également connectée à la grille d'un transistor PMOS T₁₉ dont la source est reliée d'une part à la source d'un transistor PMOS T₂₀ (pour former la paire différentielle) et d'autre part au drain du transistor T₁₈. La grille du transistor T₂₀ est par ailleurs reliée au drain de ce même transistor T₂₀.

Les trois fils 10₁, 10₂, 10₃ du bus 10 sont donc connectés respectivement à la source du transistor T₁₈ (pour connexion à la source de courant en tête de colonne), au drain du transistor T₁₉ et au drain du transistor T₂₀ (pour connexion au miroir de courant en pied de colonne).

On a représenté en figure 4 la paire différentielle 30 (transistors T₂₁, T₂₂) et le transistor T₁₇ (associés à la capacité C₁ comme décrit précédemment) et leur connexion aux éléments en tête de colonne et en pied de colonne rapidement évoquée précédemment. Par souci de simplification, les éléments (T₁₈, T₁₉, T₂₀) associés à la capacité C₂ ne sont pas représentés sur la figure 4 ; leur connexion en tête et en pied de colonne est toutefois réalisée de manière identique comme déjà expliqué en référence à la figure 3.

Comme bien visible en figure 4, la source du transistor T₁₇ recevant le signal de lecture L₁ est connectée par l'intermédiaire du fil 10₁ du bus 10 au drain d'un transistor PMOS T₂₃ situé en tête de colonne 30 et formant source de courant (du fait que sa source est mise à la tension d'alimentation Vcc).

Les drains des transistors T₂₁, T₂₂ formant la paire différentielle 34 sont quant à eux respectivement connectés par les fils 10₂, 10₃ du bus 10 aux drains de transistors NMOS T₂₄, T₂₅ situés en pied de colonne 32 et formant miroir de courant, le drain du transistor T₂₄ étant également connecté aux grilles des transistors T₂₄ et T₂₅ et les sources de ces transistors T₂₄, T₂₅ étant mises à la masse GND.

Les éléments (T₂₃, T₂₄, T₂₅) en tête de colonne 30 et en pied de colonne 32 sont communs à l'ensemble des pixels de la colonne ; ainsi, pour chacun des pixels de la colonne, le bus 10 est connecté à ces éléments T₂₃, T₂₄, T₂₅ de manière identique à ce qui vient d'être décrit pour le pixel représenté en figure 4.

On voit ainsi clairement que la fermeture du transistor T₁₇ relatif à un pixel particulier (fermeture commandée par le signal de lecture L₁) permet de connecter (entre source de courant et miroir de courant) la paire différentielle 34 du pixel concerné et de lire ainsi sur la grille du transistor T₂₂ une valeur Vs correspondant à celle mémorisée grâce à la capacité C₁ dans le pixel concerné.

On lit de la même manière la valeur mémorisée par la capacité C₂ par fermeture du transistor T₁₈ associé au moyen du signal L₂.

La valeur lue peut alors être traitée, par exemple convertie en numérique comme déjà indiqué.

Le mode de réalisation qui précède n'est naturellement qu'un exemple possible de mise en oeuvre de l'invention, qui ne s'y limite pas.

D'autres circuits que ceux présentés ci-dessus pourraient notamment être utilisés pour assurer les fonctions d'injection de charges, de comparaison et de réinitialisation.

On pourrait également prévoir de dénombrer les impulsions en réinitialisant la tension mémorisée à une valeur maximale et en décrémentant cette valeur à chaque impulsion reçue.

On a par ailleurs décrit un exemple de circuit réalisé en technologie CMOS, mais on pourrait naturellement envisager des implémentations dans d'autres technologies, telle qu'en logique bipolaire, ou avec des transistors complémentaires de ceux qui ont été décrits (auquel cas on pourra par exemple prévoir que l'impulsion en entrée soit appliquée en tête de l'inverseur correspondant à I₂).

On pourra en outre, dans le cas où la technologie de réalisation du circuit permet de disposer de transistors "*grille mince*" fonctionnant par exemple avec une tension maximale de 1,8V et de transistors "*grille épaisse*" fonctionnant par exemple avec une tension 3,3V, utiliser des transistors grille épaisse qui présentent généralement des fuites plus faibles. De tels transistors pourront avantageusement être utilisés pour réaliser le circuit d'injection de charges, les transistors de réinitialisation T_{R} et T_{RST} et le premier inverseur I₁.

## Revendications

1. Compteur analogique comprenant, pour au moins un étage :
- une entrée (eᵢ) destinée à recevoir des impulsions électriques ;
- des moyens (20ᵢ) pour modifier par incréments ou décréments successifs une tension de stockage (Vᵢ) à chaque impulsion reçue ;
- des moyens de réinitialisation (T_{R}) de la tension de stockage (Vᵢ),
- un comparateur (22ᵢ) de la tension de stockage (Vᵢ) à un seuil (Vₛₑᵤᵢₗ) apte à générer une information de dépassement (Sᵢ) ; et
- **caracterisé par** des moyens de commande (24ᵢ ; I₂) aptes à commander les moyens de réinitialisation (T_{R}) en cas de détection simultanée de l'information de dépassement (Sᵢ) du comparateur et d'une impulsion en entrée (eᵢ).

2. Compteur analogique selon la revendication 1, dans lequel le comparateur (22ᵢ) comprend des moyens de maintien de l'information de dépassement (Sᵢ) jusqu'à une réinitialisation ultérieure.

3. Compteur analogique selon la revendication 1 ou 2, comprenant des moyens pour rendre possible la détection simultanée de l'information de dépassement (Sᵢ) et de l'impulsion en entrée (eᵢ) uniquement lors de la réception d'une impulsion postérieure à une impulsion en entrée ayant entraîné la génération de l'information de dépassement (Sᵢ).

4. Compteur analogique selon l'une des revendications 1 à 3, dans lequel le comparateur (22ᵢ) a un temps de réponse supérieur à la durée des impulsions et inférieur à la période séparant deux impulsions.

5. Compteur analogique selon l'une des revendications 1 à 4, comprenant des moyens (T_{RST}) pour forcer la tension de stockage (Vᵢ) à une tension prédéterminée supérieure ou inférieure au seuil (Vₛₑᵤᵢₗ), commandés par un signal de réinitialisation forcée (RST).

6. Compteur analogique selon l'une des revendications 1 à 5, dans lequel les moyens de commande (24ᵢ ; I₂) sont aptes à transmettre, à destination de l'entrée d'un étage suivant, une impulsion conditionnée par la présence de l'information de dépassement et de ladite impulsion en entrée.

7. Compteur analogique selon l'une des revendications 1 à 6, dans lequel lesdits moyens pour modifier la tension de stockage (Vᵢ) comprennent un circuit d'injection de charges (20ᵢ).

8. Compteur analogique selon la revendication 7, dans lequel le circuit d'injection de charges (20ᵢ) comprend trois transistors PMOS (T₁, T₂, T₃) en série, dont deux transistors (T₃, T₁) d'extrémité qui reçoivent sur la grille respectivement un signal portant lesdites impulsions et un signal complémentaire dudit signal portant lesdites impulsions.

9. Compteur analogique selon l'une des revendications 1 à 8, dans lequel le comparateur (22ᵢ) comprend deux transistors (T₄, T₅) formant une paire différentielle et recevant respectivement sur leur grille la tension de stockage (Vᵢ) et le seuil (Vₛₑᵤᵢₗ), et dans lequel un transistor (T_{H}) commandé par l'information de dépassement (Sᵢ) est connecté en parallèle du transistor (T₅) recevant le seuil (Vₛₑᵤᵢₗ) de manière à le court-circuiter en présence de l'information de dépassement.

10. Compteur analogique selon l'une des revendications 1 à 9, **caractérisé en ce que** les moyens de commande (24ᵢ ; I₂) comprennent un inverseur (I₂) recevant en entrée l'information de dépassement (Sᵢ) et dont une borne de polarisation est connectée à ladite entrée (eᵢ).

11. Compteur analogique selon la revendication 10, dans lequel un autre inverseur (I₁) est apte à mettre en forme l'information de dépassement (Sᵢ) reçue du comparateur.

12. Imageur comprenant plusieurs pixels, chaque pixel comprenant des moyens de mesure générant un signal électrique porteur d'impulsions dont la fréquence est représentative d'un rayonnement reçu par ce pixel, et un compteur analogique selon l'une des revendications 1 à 11, le signal électrique étant appliqué à ladite entrée du compteur.

## Claims

1. An analog counter comprising, for at least one stage:
- an input (eᵢ) adapted to receive electrical pulses;
- means (20ᵢ) for modifying, by successive increments or decrements, a storage voltage (Vᵢ) at each pulse received;
- means (T_{R}) for resetting the storage voltage (Vᵢ),
- a comparator (22ᵢ) for comparing the storage voltage (Vᵢ) with a threshold (V_{threshold}) adapted to generate exceedance information (Sᵢ); and **characterized by**
- control means (24ᵢ ; I₂) adapted to control the resetting means (T_{R}) in case of simultaneous detection of the exceedance information (Sᵢ) from the comparator and of an input pulse (eᵢ).

2. An analog counter according to claim 1, wherein the comparator (22ᵢ) comprises means for maintaining the exceedance information (Sᵢ) until later resetting.

3. An analog counter according to claim 1 or 2, comprising means for enabling the simultaneous detection of the exceedance information (Sᵢ) and of the input pulse (eᵢ) uniquely on reception of a pulse subsequent to an input pulse that led to the generation of the exceedance information (Sᵢ).

4. An analog counter according to one of claims 1 to 3, wherein the comparator (22ᵢ) has a response time greater than the duration of the pulses and less than the period separating two pulses.

5. An analog counter according to one of claims 1 to 4, comprising means (T_{RST}) for forcing the storage voltage (Vᵢ) to a predetermined voltage greater than or less than the threshold (V_{threshold}), that are controlled by a forced resetting signal (RST).

6. An analog counter according to one of claims 1 to 5, wherein the control means (24ᵢ ; I₂) are adapted to transmit a pulse to the input of a following stage which pulse depends on the presence of the exceedance information and said input pulse.

7. An analog counter according to one of claims 1 to 6, wherein said means for modifying the storage voltage (Vᵢ) comprise a charge injection circuit (20ᵢ).

8. An analog counter according to claim 7, wherein the charge injection circuit (20ᵢ) comprises three PMOS transistors (T₁, T₂, T₃) in series, of which two are end transistors (T₃, T₁) which receive on the gate respectively a carrying signal of said pulses and a signal that is complementary to said carrying signal of said pulses.

9. An analog counter according to one of claims 1 to 8, wherein the comparator (22ᵢ) comprises two transistors (T₄, T₅) forming a differential pair and respectively receiving on their gate the storage voltage (Vᵢ) and the threshold (V_{threshold}), and in which a transistor (T_{H}) controlled by the exceedance information (Sᵢ) is connected in parallel to the transistor (T₅) receiving the threshold (V_{threshold}) so as to short-circuit it in the presence of the exceedance information.

10. An analog counter according to one of claims 1 to 9, **characterized in that** the control means (24ᵢ ; I₂) comprise an inverter (I₂) receiving as input the exceedance information (Sᵢ) and of which a bias terminal is connected to said input (eᵢ).

11. An analog counter according to claim 10, wherein another inverter (I₁) is adapted to put into form the exceedance information (Sᵢ) received from the comparator.

12. An imaging device comprising several pixels, each pixel comprising measuring means generating an electrical carrying signal of pulses the frequency of which represents a radiation received by that pixel, and an analog counter according to one of claims 1 to 11, the electrical signal being applied to said input of the counter.

## Patentansprüche

1. Analogzähler, enthaltend für zumindest eine Stufe:
- einen Eingang (eᵢ), der dazu bestimmt ist, elektrische Impulse zu empfangen;
- Mittel (20ᵢ), um durch aufeinanderfolgende Inkremente bzw. Dekremente eine Speicherspannung (Vᵢ) bei jedem empfangenen Impuls zu modifizieren;
- Mittel (T_{R}) zum Reinitialisieren der Speicherspannung (Vᵢ);
- einen Komparator (22ᵢ) der Speicherspannung (Vᵢ) mit einem Schwellwert (Vₛₑᵤᵢₗ), der dazu geeignet ist, eine Überschreitungsmeldung (Sᵢ) zu erzeugen; und
**gekennzeichnet durch**
- Steuermittel (24ᵢ; I₂), die dazu geeignet sind, die Reinitialisierungsmittel (T_{R}) im Falle der gleichzeitigen Erfassung der Überschreitungsmeldung (Sᵢ) des Komparators und eines Impulses am Eingang (eᵢ) anzusteuern.

2. Analogzähler nach Anspruch 1,
wobei der Komparator (22ᵢ) Mittel zum Beibehalten der Überschreitungsmeldung (Sᵢ) bis zu einer späteren Reinitialisierung aufweist.

3. Analogzähler nach Anspruch 1 oder 2,
enthaltend Mittel, um die gleichzeitige Erfassung der Überschreitungsmeldung (Sᵢ) und des Eingangsimpulses (eᵢ) nur bei Empfang eines Impulses zu gestatten, welcher nach einem Eingangsimpuls erfolgt, der zum Erzeugen der Überschreitungsmeldung (Sᵢ) geführt hat.

4. Analogzähler nach einem der Ansprüche 1 bis 3,
wobei der Komparator (22ᵢ) eine Ansprechzeit hat, die länger als die Dauer der Impulse und kürzer als die Zeitspanne ist, die zwei Impulse trennt.

5. Analogzähler nach einem der Ansprüche 1 bis 4,
enthaltend Mittel (T_{RST}), um die Speicherspannung (Vᵢ) auf eine vorbestimmte Spannung zu zwingen, die über oder unter dem Schwellwert (Vₛₑᵤᵢₗ) liegt, welche Mittel über ein Signal zur erzwungenen Reinitialisierung (RST) angesteuert werden.

6. Analogzähler nach einem der Ansprüche 1 bis 5,
wobei die Steuermittel (24ᵢ; l₂) dazu geeignet sind, dem Eingang einer nachfolgenden Stufe einen Impuls zu übertragen, der durch das Vorliegen einer Überschreitungsmeldung und des Eingangsimpulses bedingt ist.

7. Analogzähler nach einem der Ansprüche 1 bis 6,
wobei die Mittel zum Modifizieren der Speicherspannung (Vᵢ) eine Ladungsinjektionsschaltung (20ᵢ) aufweisen.

8. Analogzähler nach Anspruch 7,
wobei die Ladungsinjektionsschaltung (20ᵢ) drei PMOS-Transistoren (T₁, T₂, T₃) in Reihe aufweist, darunter zwei Endtransistoren (T₃, T₁), die am jeweiligen Gate ein die Impulse tragendes Signal bzw. ein zu dem die Impulse tragenden Signal komplementäres Signal empfangen.

9. Analogzähler nach einem der Ansprüche 1 bis 8,
wobei der Komparator (22ᵢ) zwei Transistoren (T₄, T₅) aufweist, die ein differentielles Paar bilden und jeweils an ihrem Gate die Speicherspannung (Vᵢ) und den Schwellwert (Vₛₑᵤᵢₗ) empfangen, und wobei ein über die Überschreitungsmeldung (Sᵢ) angesteuerter Transistor (T_{H}) parallel zu dem den Schwellwert (Vₛₑᵤᵢₗ) empfangenden Transistor (T₅) geschaltet ist, so dass er bei einer vorhandenen Überschreitungsmeldung kurzgeschlossen wird.

10. Analogzähler nach einem der Ansprüche 1 bis 9,
**dadurch gekennzeichnet, dass** die Steuermittel (24ᵢ; l₂) einen Inverter (l₂) aufweisen, der am Eingang die Überschreitungsmeldung (Si) empfängt und von dem eine Polarisierungsklemme mit dem Eingang (ei) verbunden ist.

11. Analogzähler nach Anspruch 10,
wobei ein weiterer Inverter (l₁) dazu geeignet ist, die ausgehend von dem Komparator empfangene Überschreitungsmeldung (Sᵢ) aufzubereiten.

12. Bildgeber mit mehreren Pixeln, wobei jedes Pixel Messmittel aufweist, die ein elektrisches Impulsträgersignal erzeugen, dessen Frequenz repräsentativ ist für eine von diesem Pixel empfangene Strahlung, und mit einem Analogzähler nach einem der Ansprüche 1 bis 11, wobei das elektrische Signal an den Eingang des Zählers angelegt wird.
